Europäisches Patentamt

European Patent Office

Office européen des brevets

(19)

(11) Numéro de publication : **0 109 899**
**B1**

(12)

# FASCICULE DE BREVET EUROPÉEN

(45) Date de publication du fascicule du brevet :
15.04.87

(51) Int. Cl.⁴ : **H 01 L 23/56**, H 01 L 23/04

(21) Numéro de dépôt : 83402201.4

(22) Date de dépôt : 15.11.83

(54) **Module préadapté pour diode hyperfréquence à forte dissipation thermique.**

(30) Priorité : 23.11.82 FR 8219585

(43) Date de publication de la demande :
30.05.84 Bulletin 84/22

(45) Mention de la délivrance du brevet :
15.04.87 Bulletin 87/16

(84) Etats contractants désignés :
DE GB NL

(56) Documents cités :
EP-A- 0 018 174
DE-A- 2 348 832
FR-A- 2 244 264
US-A- 4 189 342
IEEE TRANSACTIONS ON MICROWAVE THEORY
AND TECHNIQUES, vol. MTT-27, no. 5, mai 1979,
pages 483-492, IEEE, New York, US, T.A. MIDFORD et
al.: "Millimeter-wave CW IMPATT diodes and oscillators"

(73) Titulaire : THOMSON-CSF
173, Boulevard Haussmann
F-75379 Paris Cedex 08 (FR).

(72) Inventeur : Heitzmann, Michel
THOMSON-CSF SCPI 173, bld Haussmann
F-75379 Paris Cedex 08 (FR)
Inventeur : Boudot, Marianne
THOMSON-CSF SCPI 173, bld Haussmann
F-75379 Paris Cedex 08 (FR)

EP 0 109 899 B1

## Description

La présente invention se rapporte d'une manière générale aux diodes hyperfréquences travaillant notamment dans la bande 94 GHz et encapsulées dans un boîtier en vue de réaliser un module préadapté par utilisation des dimensions du boîtier d'encapsulation, et concerne plus particulièrement un tel module préadapté pour diode hyperfréquence à forte dissipation thermique.

On entend par module préadapté un module permettant d'adapter l'impédance faible de la diode à l'impédance élevée du milieu environnant, généralement l'air.

En outre, on sait que l'adaptation d'impédance est nécessaire en hyperfréquence, surtout à des fréquences proches de 100 GHz, pour une diode qui doit rayonner dans l'espace qui l'entoure. Cette adaptation est particulièrement intéressante sous une forme radiale car elle peut être obtenue grâce à un boîtier ad hoc.

On connaît déjà une structure de module préadapté ou préaccordé pour une diode hyperfréquence, de type Gunn, à avalanche, ou Schottky, comme cela est décrit dans la demande de brevet européen EP-A-89 898 déposée au nom de la Demanderesse et publiée le 28 septembre 1983, concernant : « Module préadapté pour une diode hyperfréquence, et procédé de réalisation de la connexion de polarisation de la diode ». Selon cette demande de brevet, le module préadapté comporte une pastille de diode fixée à l'intérieur d'un boîtier d'encapsulation constitué d'une embase métallique à plot ou picot central constituant une première connexion, un anneau de quartz entourant la diode, un capot métallique, et une seconde connexion de type faux beam-lead se présentant sous forme d'une étoile métallique non plane dont l'extrémité des branches s'appuie sur la face de l'anneau de quartz en contact avec le capot de fermeture, et dont le centre est en contact avec la pastille de diode.

De plus, lors de l'utilisation en régime continu ou en régime pulsé de la diode, la partie de la jonction qui s'échauffe le plus est la partie proche de l'embase métallique. Il se pose alors le problème de l'évacuation de la chaleur dégagée par la jonction en fonctionnement. A cet effet, selon la demande de brevet antérieure précédemment citée, la pastille de diode est équipée d'un radiateur thermique intégré constitué par une lamelle d'or de petites dimensions, à savoir 200 microns de côté et 50 microns d'épaisseur, qui est rapportée sur l'embase métallique.

Toutefois, en raison de ses petites dimensions et de la valeur de la conductivité thermique de l'or, de l'ordre de 3,1 W/cm °K à 200 °C, un tel radiateur d'or ne dissipe pas autant qu'on le souhaiterait la chaleur engendrée par la diode pendant son utilisation. De plus, avec ce type de radiateur thermique, la résistance thermique totale de la diode est relativement élevée, ce qui limite la puissance de sortie délivrée par la diode.

Cette puissance de sortie peut être augmentée si la résistance thermique est abaissée. Une solution est décrite dans le document « Millimeter Wave CW IMPATT Diodes and Oscillators » publié dans IEEE Transactions on Microwave Theory and Techniques, vol. MTT 27, N° 5, mai 1979. Selon cet article, la pastille de diode est montée sur un diamant qui est incrusté dans un radiateur de cuivre. La plaquette de diamant, soudée ou pressée dans le cuivre, a une face supérieure coplanaire avec celle du radiateur : elle sert à favoriser la circulation des calories dégagées par la diode depuis une pastille de diode petite vers un radiateur grand. Mais son rôle est purement technique : ce diamant n'intervient pas dans l'adaptation d'impédance radiale de la diode, puisque, sa face supérieure étant coplanaire avec celle du radiateur, son diamètre n'intervient pas dans une transformation d'impédance.

La présente invention a pour but de remédier à ces inconvénients en proposant une diode hyperfréquence, notamment dans la bande 94 GHz, qui est encapsulée dans un boîtier tel que l'on réalise un module préadapté, et qui est équipée d'un radiateur thermique dont les dimensions et le matériau le constituant assurent une forte dissipation thermique, et dont la forme permet de reconstituer la géométrie module préadapté au voisinage immédiat de la diode, de façon à assurer une bonne transformation radiale d'impédance.

A cet effet, l'invention a pour objet un module préadapté pour diode hyperfréquence à forte dissipation thermique, comportant une pastille de diode et un boîtier dans lequel est montée la diode, le boîtier comprenant une embase métallique ou métallisée constituant une première connexion, un anneau de diélectrique entourant la diode, un capot métallique et une seconde connexion métallique en contact avec la diode et avec la face de l'anneau de diélectrique venant en contact avec le capot, l'embase comportant une première partie d'embase de la diode constituée par un diamant métallisé sur toutes ses faces, ce module étant caractérisé en ce que l'embase de la diode comprend en outre une seconde partie constituée par un diamant métallisé sur toutes ses faces, en ce que la première partie d'embase est de dimensions très supérieures à celles de la seconde partie, de sorte que la seconde partie appliquée sur la première partie forme un plot central, la diode étant fixée sur la face supérieure de la seconde partie d'embase et la face de l'anneau de diélectrique opposée à celle en contact avec le capot étant rapportée sur la face supérieure de la première partie d'embase, et en ce que les dimensions respectives des deux parties d'embase sont telles que le capot assure, par ses dimensions et celles de la seconde partie d'embase et de l'anneau de diélectrique, la transformation radiale d'impédance de la diode, et que les deux parties d'embase assurent l'évacuation de la chaleur dégagée par la diode.

On comprend qu'ainsi la présence de deux diamants rapportés, l'un de grandes dimensions et l'autre de petites dimensions, et dont la conductivité thermique, de l'ordre de 10 W/cm °K à 200 °C, est très nettement supérieure à celle de l'or selon l'art antérieur, permettra d'une part d'évacuer au maximum, par ces diamants, la chaleur dégagée par la diode lors de son utilisation, et d'autre part de diminuer la résistance thermique totale de la diode, donc d'augmenter la puissance de sortie de la diode. De plus, les deux diamants métallisés et rapportés dont l'un forme un plot ou picot central reconstitueront la forme habituelle de l'embase métallique du boîtier d'encapsulation de la diode, qui est nécessaire pour assurer une bonne transformation radiale d'impédance.

D'autres caractéristiques et avantages de l'invention apparaîtront mieux dans la description détaillée qui suit et se réfère aux dessins annexés, donnés uniquement à titre d'exemple et dans lesquels :

la figure 1 représente un schéma d'adaptation d'impédance d'une diode à l'espace l'entourant ;

la figure 2 représente une courbe de puissance d'une diode en fonction du courant ou de la température ambiante pour une médiocre et une bonne transformation d'impédance ; et

la figure 3 représente un boîtier d'encapsulation d'une diode adaptée en impédance et à forte dissipation thermique selon l'invention.

On rappellera tout d'abord qu'une pastille de diode hyperfréquence travaillant par exemple dans la bande 94 GHz, encapsulée et montée dans son boîtier, présente une impédance du type R + jX, dans lequel R représente la partie réelle de la résistance de la diode et X la partie imaginaire de cette résistance, j étant représentatif des imaginaires. R est négatif pour une diode à avalanche ou une diode Gunn, et est positif pour une diode Schottky ou d'un autre type.

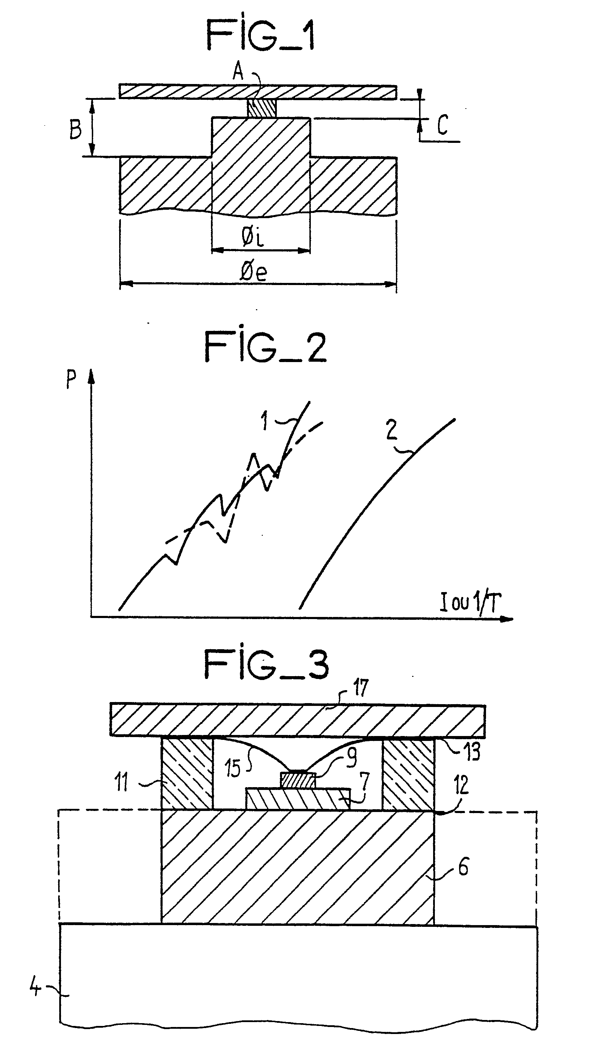

La figure 1 aidera à mieux comprendre l'importance de l'adaptation d'impédance d'une diode à son boîtier d'encapsulation.

Sur cette figure 1, on a représenté en A la diode dans laquelle la pastille de semi-conducteur est soudée sur une embase métallique à plot ou picot central et comporte une connexion supérieure : soit $\Phi_i$ le diamètre du plot métallique sur lequel est soudée la diode A, $\Phi_e$ le diamètre de l'embase, c'est-à-dire également le diamètre intérieur de la cavité, B la distance qui sépare la connexion supérieure de l'embase, et C l'épaisseur de la diode ou encore la distance qui sépare la connexion supérieure du plot sur lequel est soudée la pastille. La pastille de diode est entourée d'un diélectrique de constante donnée, ou de plusieurs diélectriques de constantes différentes qui donnent une constante diélectrique équivalente moyenne. Selon les cas, le diélectrique qui entoure la pastille est soit de l'air, soit un isolant sous forme de résine. On démontre que l'impédance de l'espace entourant la diode ayant une valeur $R_e + jX_e$ ramenée à la périphérie, il existe un ensemble unique de valeurs de $\Phi_i$, $\Phi_e$, B et C telles qu'il y a adaptation d'impédance du dispositif semi-conducteur, soit :

$$R_e = k_1R \text{ et } X_e = k_2X$$

Cependant, dans la pratique, il suffit que $k_1R$ et $k_2X$ s'approchent suffisamment de $R_e$ et $X_e$ car alors les accords mécaniques classiques dans la monture deviennent extrêmement aisés ; c'est pourquoi l'on dit préadaptation et non pas adaptation.

Cette transformation d'impédance est extrêmement intéressante en particulier pour les diodes à avalanche, car elle simplifie considérablement la cavité : par exemple, la polarisation sur l'électrode supérieure peut être réalisée par un simple fil fin.

En outre, et ceci est montré sur la figure 2, la courbe de la puissance délivrée P en fonction d'une autre variable telle que le courant de polarisation 1 ou l'inverse de la température ambiante 1/T, est très monotone sans hystérésis ou sans accroc. Ainsi, sur la figure 2, la courbe 1 représente la courbe de puissance de diodes encapsulées dans un boîtier sans adaptation d'impédance : cette courbe ne connaît pas une variation régulière, mais au contraire présente des décrochages, ceux-ci variant de plus d'une diode à l'autre selon le boîtier. Au contraire, la courbe 2 qui présente une variation très régulière correspond à une diode correctement encapsulée dans un boîtier avec adaptation d'impédance.

Ceci montre l'importance qu'il y a, surtout à de telles fréquences proches de 100 GHz, à ce qu'une pastille de diode soit correctement encapsulée et montée dans son boîtier, qui fait cavité, tout ceci de préférence à partir de pièces réalisées de façon collective.

La figure 3 représente un boîtier d'encapsulation d'une diode hyperfréquence à forte dissipation thermique, conforme à l'invention, telle que par exemple une diode à avalanche en silicium à 94 GHz, et adaptée ou préadaptée suffisamment en impédance.

Le boîtier comporte tout d'abord une embase métallique ou métallisée constituée par les trois parties suivantes.

La première partie d'embase est constituée par un support métallique 4 en cuivre nickelé et doré, de section droite circulaire, de diamètre par exemple égal à 1,6 mm.

Sur ce support 4, est rapportée, généralement par brasure, la seconde partie d'embase constituée par un matériau à haute conductivité thermique, tel qu'un diamant IIA, repéré en 6, qui est une variété cristallographique du diamant commercialisé par la Société sud-africaine DRUCKER et dont la conductivité thermique est nettement supérieure à celle de n'importe quel métal, et en particulier l'or.

Ce premier diamant 6 est par exemple de forme parallélépipédique de section droite carrée, et est de grandes dimensions, à savoir par exemple 750 microns de côté et 500 microns d'épaisseur. Ce grand diamant 6 est de plus métallisé sur toutes ses faces par des dépôts successifs de titane (par exemple 300 Å), de platine (par exemple 600 Å) et d'or (par exemple 1 micron).

La troisième partie d'embase du boîtier est constituée également d'un matériau à haute conductivité thermique, tel qu'un diamant IIA, repéré en 7, et rapporté par thermocompression sur le grand diamant 6. Le diamant 7 est également par exemple de forme parallélépipédique de section droite carrée, et présente des dimensions très inférieures à celles du diamant 6, à savoir par exemple 200 microns de côté et 50 microns d'épaisseur. Ce petit diamant 7 est également métallisé sur toutes ses faces, par des dépôts successifs de titane, de platine et d'or, comme pour le grand diamant 6 décrit ci-dessus.

Ainsi, du fait de la différence entre les dimensions respectives des deux diamants 6 et 7, le petit diamant 7 forme un plot ou picot central, de sorte que ces deux diamants métallisés et rapportés reconstituent la même forme d'embase métallique représentée sur la figure 1, ce qui est indispensable pour assurer une bonne transformation radiale d'impédance.

On notera que le support métallique 4 en cuivre nickelé et doré peut également remonter autour du grand diamant 6 comme indiqué par les pointillés, sans sortir du cadre de l'invention ; ceci est obtenu soit par une croissance électrolytique de cuivre avant dépôts de nickel et d'or, soit par un sertissage du diamant 6 dans le support 4.

Comme il apparaît sur la figure 3, une pastille de diode 9, par exemple de 45 microns de diamètre et de 5 microns d'épaisseur, est thermocomprimée sur la face supérieure du petit diamant 7. Un anneau de diélectrique 11, comme par exemple le quartz qui présente de faibles pertes dans la bande 94 GHz, est thermocomprimé, collé ou brasé autour de la pastille de diode 9 sur la face supérieure du grand diamant 6. Cet anneau 11 servant d'encapsulation de la diode, et métallisé sur ses deux faces 12 et 13, a un diamètre extérieur compris entre 750 et 800 microns, un diamètre intérieur compris entre 350 et 400 microns, et une épaisseur de l'ordre de 120 microns.

Une connexion supérieure 15, par exemple en forme de faux beam-lead, est rapportée sur la pastille de diode 9 : elle s'appuie sur la face supérieure 13 de l'anneau de quartz 11, et l'ensemble est refermé par un couvercle ou capot métallique 17 en cuivre doré, par exemple de section droite circulaire, et thermocomprimé, collé ou brasé sur la face supérieure de l'anneau de quartz. Le capot 17 a un diamètre de l'ordre de 1,1 à 1,2 mm et une épaisseur de 100 microns.

La connexion 15 de la diode est par exemple du type décrit dans la demande de brevet n° 8 204 920 du 23 mars 1982 déjà citée, c'est-à-dire en forme d'étoile métallique dont les deux branches ne sont pas planes, mais s'éloignent de l'embase, ce qui diminue l'inductance et la capacité parasites.

Ainsi, lors de l'utilisation en régime continu ou en régime pulsé de la diode 9, les deux diamants métallisés 6 et 7, et notamment le grand diamant 6, assurent au maximum l'évacuation de la chaleur dégagée par la jonction en fonctionnement, tout en permettant au capot 17 d'assurer, par son diamètre, la transformation radiale d'impédance de la diode 9 à la fréquence d'oscillation du module.

Par conséquent, les grand (6) et petit (7) diamants rapportés et métallisés remplissent ensemble une double fonction :

une dissipation thermique qualifiée d'excellente grâce au matériau de haute conductivité thermique (diamant) des deux parties d'embase 6 et 7 et aux grandes dimensions du diamant 6 ;

une reconstitution de la forme habituelle d'une embase métallique de boîtier d'encapsulation d'une diode aux petites dimensions du diamant métallisé central 7 vis-à-vis de celles du diamant métallisé 6, pour assurer une bonne transformation radiale d'impédance.

De plus, on notera que si le diamant 7 n'existait pas, la self introduite par la connexion supérieure 15 serait souvent prohibitive.

**Revendications**

1. Module préadapté pour diode hyperfréquence à forte dissipation thermique, comportant une pastille de diode (9) et un boîtier dans lequel est montée la diode, le boîtier comprenant une embase métallique ou métallisée (4, 6, 7) constituant une première connexion, un anneau de diélectrique (11) entourant la diode, un capot métallique (17) et une seconde connexion métallique (15) en contact avec la diode et avec la face de l'anneau de diélectrique venant en contact avec le capot, l'embase comportant une première partie d'embase de la diode constituée par un diamant (6) métallisé sur toutes ses faces, ce module étant caractérisé en ce que l'embase de la diode comprend en outre une seconde partie constituée par un diamant (7) métallisé sur toutes ses faces, en ce que la première partie d'embase (6) est de dimensions très supérieures à celles de la seconde partie (7), de sorte que la seconde partie appliquée sur la première partie forme un plot central, la diode (9) étant fixée sur la face supérieure de la seconde partie d'embase (7) et la face de l'anneau de diélectrique opposée à celle en contact avec le capot étant rapportée sur la face supérieure de la première partie d'embase (6), et en ce que les dimensions respectives des deux parties d'embase (6, 7) sont telles que le capot (17) assure, par ses dimensions et celles de la seconde partie d'embase (7) et de l'anneau de diélectrique (11), la transformation radiale d'impédance de la diode, et que les deux parties d'embase (6, 7) assurent l'évacuation de la chaleur dégagée par la diode.

2. Module préadapté selon la revendication 1, caractérisé en ce que le diamant de chacune des première (6) et seconde (7) parties d'embase est du type II A.

3. Module préadapté selon l'une des revendications 1 ou 2, caractérisé en ce que chacune des première (6) et seconde (7) partie d'embase est de forme parallélépipédique de section droite carrée.

4. Module préadapté selon la revendication 3, caractérisé en ce que la première partie d'embase (6) a 750 microns de côté et 500 microns d'épaisseur, et en ce que la seconde partie d'embase (7) a 200 microns de côté et 50 microns d'épaisseur.

5. Module préadapté selon l'une des revendications précédentes, caractérisé en ce que la seconde partie d'embase (7) est appliquée par thermocompression sur la première partie (6).

6. Module préadapté selon l'une des revendications précédentes, caractérisé en ce que chacune des première (6) et seconde (7) parties d'embase est métallisée par des dépôts successifs de titane, de platine et d'or.

7. Module préadapté selon l'une des revendications précédentes, caractérisé en ce que l'anneau de diélectrique (11) est rapporté par thermocompression sur la première partie d'embase (6).

8. Module préadapté selon l'une des revendications précédentes, caractérisé en ce que l'embase du boîtier comporte de plus une troisième partie formant support métallique (4) en cuivre nickelé et doré sur lequel est rapportée la face inférieure de la première partie d'embase (6).

**Claims**

1. A pre-adapted module for a microwave diode having a high thermal dissipation, the module comprising a diode chip (9) and a casing in which the diode is mounted, the casing including a metal or metal coated base (4, 6, 7) constituting a first connection, a dielectric ring (11) surrounding the diode, a metal cap (17) and a second metal connection (15) in contact with the diode and with that face of the dielectric ring which is in contact with the cap, the base comprising a first diode base portion constituted by a diamond (6) which is metal coated on all its surfaces, characterized in that the diode base further comprises a second portion constituted by a diamond (7) metal coated on all its surfaces, that the first base portion (6) is very much larger than the second portion (7), such that the second portion, when applied on the first portion, constitutes a central stud, the diode (9) being fixed to the upper surface of the second base portion (7) and the dielectric ring surface opposite to that which is in contact with the cap being applied onto the upper surface of the first base portion (6), and that the dimensions of the two base portions (6, 7) are such that the cap (17) ensures, by its dimensions and that of the second base portion (7) and of the dielectric ring (11), the radial impedance transformation of the diodes, and that the two base portions (6, 7) ensure the extraction of heat created by the diode.

2. A pre-adapted module according to claim 1, characterized in that the diamonds of the first and the second base portions (6, 7) are of the II A type.

3. A pre-adapted module according to one of claims 1 or 2, characterized in that the first and second base portions (6, 7) are each of parallelepipedic shape and of square cross-section.

4. A pre-adapted module according to claim 3, characterized in that the first base portion (6) has a side length of 750 μm and a thickness of 500 μm and that the second base portion (7) has a side length of 200 μm and a thickness of 50 μm.

5. A pre-adapted module according to one of the preceding claims, characterized in that the second base portion (7) is applied to the first portion by thermo-compression.

6. A pre-adapted module according to one of the preceding claims, characterized in that the first and second base portions (6, 7) are each metallized by successive coatings with titanium, platinum and gold.

7. A pre-adapted module according to one of the preceding claims, characterized in that the dielectric ring (11) is applied to the first base portion (6) by thermo-compression.

8. A pre-adapted module according to one of the preceding claims, characterized in that the base of the casing further comprises a third portion constituting a metal support (4) made of copper which is coated by nickel and then by gold and to which the lower surface of the first base portion (6) is bond.

**Patentansprüche**

1. Vorangepaßter Modul für eine Mikrowellendiode mit starker Wärmeentwicklung, mit einer Diodenpastille (9) und einem Gehäuse, in dem die Diode montiert ist, wobei das Gehäuse eine metallische oder metallisierte Basis (4, 6, 7), die einen ersten Anschluß bildet, einen dielektrischen Ring (11), der die Diode umgibt, eine metallische Haube (17) und einen zweiten metallischen Anschluß (15) besitzt, der mit der Diode und mit der in Kontakt mit der Haube stehenden Seite des dielektrischen Rings in Berührung steht, wobei die Basis ein erstes Basisteil der Diode besitzt, das von einem an allen seinen Oberflächen metallisierten Diamant (6) gebildet wird, dadurch gekennzeichnet, daß die Basis der Diode außerdem ein zweites Teil aufweist, das von einem an allen seinen Oberflächen metallisierten Diamant (7) gebildet wird, daß das erste Basisteil (6) wesentlich größere Abmessungen als das zweite Teil (7) besitzt, derart, daß das zweite Teil, das auf den ersten Teil aufgesetzt ist, einen zentralen Anschlußpunkt bildet, wobei die Diode (9) auf der Oberseite des zweiten Basisteils (7) befestigt ist und die der mit der Haube in Kontakt stehenden Seite entgegengesetzte Seite des dielektrischen Rings auf die Oberseite des ersten Basisteils (6) aufgebracht ist, und daß die Abmessungen der beiden Basisteile (6, 7) so gewählt sind, daß die Haube (17) aufgrund ihrer Abmessungen und der Abmessungen des zweiten Basisteils (7) und des dielektrischen Rings (11) die radiale Impedanztransformation der Diode bewirkt und daß die beiden Basisteile die von der Diode erzeugte Wärme abführen.

2. Vorangepaßter Modul nach Anspruch 1, dadurch gekennzeichnet, daß die Diamanten der beiden Basisteile (6, 7) vom Typ II A sind.

3. Vorangepaßter Modul nach einem der Ansprüche 1 oder 2, dadurch gekennzeichnet, daß die beiden Basisteile (6, 7) je eine parallelepipedische Form mit quadratischem Querschnitt aufweisen.

4. Vorangepaßter Modul nach Anspruch 3, dadurch gekennzeichnet, daß das erste Basisteil (6) eine Seitenlänge von 750 μm und eine Dicke von 500 μm aufweist und daß das zweite Basisteil (7) eine Kantenlänge von 200 μm und eine Dicke von 50 μm besitzt.

5. Vorangepaßter Modul nach einem der vorhergehenden Ansprüche, dadurch gekennzeichnet, daß das zweite Basisteil (7) durch Thermokompression auf den ersten Bereich (6) aufgebracht ist.

6. Vorangepaßter Modul nach einem der vorhergehenden Ansprüche, dadurch gekennzeichnet, daß die beiden Basisteile (6, 7) je durch aufeinanderfolgende Abscheidung von Titan, von Platin und von Gold metallisiert sind.

7. Vorangepaßter Modul nach einem der vorhergehenden Ansprüche, dadurch gekennzeichnet, daß der dielektrische Ring (11) durch Thermokompression auf das erste Basisteil (6) aufgebracht ist.

8. Vorangepaßter Modul nach einem der vorhergehenden Ansprüche, dadurch gekennzeichnet, daß die Basis des Gehäuses außerdem ein drittes Teil aufweist, das einen metallischen Sockel (4) aus vernickeltem und vergoldetem Kupfer bildet, auf den die Innenseite des ersten Basisteils aufgebracht ist.

# FIG_1

A

B

C

Øi

Øe

# FIG_2

P

1

2

I ou 1/T

# FIG_3

17

15    9

11    13

7

12

6

4